# FASCICULE DE BREVET EUROPEEN

(11) **EP 2 410 472 B1**
(45) Date de publication et mention de la délivrance du brevet: **23.10.2019**
(21) Numéro de dépôt: 11174467.8
(22) Date de dépôt: 19.07.2011
(51) Int. Cl.: G06K 19/077

(54) **Insert à transpondeur et dispositif comprenant un tel insert**
Transponder-Einsatz und Vorrichtung, die einen solchen Einsatz umfasst
Transponder insert and device including such an insert

(30) Priorité: 20.07.2010 FR 1055890
(43) Date de publication de la demande: 25.01.2012
(73) Titulaire: IDEMIA France, 92700 Colombes (FR)
(72) Inventeur: Launay, François, 35500 VITRE (FR); Le Garrec, Loïc, 35500 VITRE (FR)
(74) Mandataire: Perrot, Emilie

(56) Documents cités:
- EP-A1- 0 952 542
- EP-A1- 2 043 028
- WO-A1-2005/088704
- DE-A1-102008 022 016
- FR-A1- 2 915 010

## Description

La présente invention concerne le domaine technique des dispositifs électroniques de type sans contact comprenant une antenne de communication à champ proche pour l'établissement d'une communication avec un terminal externe de lecture.

De tels dispositifs sont généralement portables et sans fil et sont aptes à échanger des données avec le terminal externe de lecture.

L'invention s'applique plus particulièrement à des dispositifs électroniques tels qu'une carte à puce ou une page d'un passeport.

Il est connu de l'état de la technique de fabriquer une page d'un passeport avec une structure multicouche à l'intérieur de laquelle un insert est incorporé.

Un insert, désigné selon la terminologie anglo-saxonne par le terme « inlay », est généralement incorporé entre deux couches d'une structure multicouche formant un support du dispositif sans contact. L'insert comprend généralement un substrat et un ensemble transpondeur formé par une antenne et un microcircuit raccordé à l'antenne. Habituellement, l'antenne et le microcircuit sont directement incorporés dans le substrat et l'antenne suit le contour externe du substrat. Ainsi, la puce (ou microcircuit) et l'antenne sont logées dans l'épaisseur de la structure multicouche formant la page de passeport. Le document EP 2 043 028 A1 décrit un tel insert à transpondeur.

L'antenne est par exemple une antenne de transmission à distance d'informations, de signaux et/ou d'énergie qui est formée par exemple par un enroulement de spires électroniquement conductrices formées par exemple par impression d'une encre conductrice sur une face de l'insert et l'antenne est connectée électriquement au microcircuit. Le document EP 0 952 542 A1 décrit un tel module à microcircuit.

Dans le cas du passeport, l'insert est par exemple intercalé entre la couverture et la page de garde, l'ensemble étant par la suite laminé pour former une unique page du passeport, par exemple par collage à froid, laminage à chaud entre la couverture et la page de garde.

Le microcircuit présente des bornes de connexion qui sont destinées à venir directement en contact avec les plots de connexion de l'antenne incorporée dans l'insert.

De la même façon, une carte à microcircuit est fabriquée à partir d'une structure multicouche dans laquelle l'insert est également incorporé ce qui permet de loger le microcircuit et l'antenne dans l'épaisseur de la carte.

Un tel procédé de fabrication se révèle être particulièrement complexe à réaliser du fait de la connexion entre l'antenne et le microcircuit qui doit être la plus fiable possible pour éviter des désolidarisations intempestives de l'antenne et du microcircuit pouvant rendre hors d'usage la carte ou le passeport.

En effet, il est nécessaire, notamment pour les documents officiels tels que les passeports, que la durée de vie d'un tel document soit suffisamment longue pour couvrir la durée de validité du titre défini par le passeport.

L'invention a notamment pour but de proposer un dispositif sans contact tel qu'un passeport ou une carte à microcircuit simple à fabriquer et fiable.

A cet effet, l'invention a pour objet un insert à transpondeur selon la revendication 1.

L'invention a encore pour objet un dispositif comprenant un support formé par une structure en couche comprenant au moins trois couches, une couche intermédiaire intercalée entre deux couches externes, caractérisé en ce que la couche intermédiaire est un insert selon l'invention.

De préférence, les couches sont liées entre elles par lamination pour former un support laminé.

Dans un mode de réalisation préféré, le dispositif est un passeport ou une carte à microcircuit.

D'autres caractéristiques et avantages de l'invention apparaîtront à la lumière de la description qui suit, faite en référence aux dessins annexés dans lesquels :
- la figure 1 représente un insert selon l'invention ;
- la figure 2 représente un insert selon une variante de l'insert de la figure 1 ;
- la figure 3 représente une carte à microcircuit de type sans contact comprenant l'insert représenté sur la figure 2 ;
- la figure 4 représente un passeport avec une fonction de type sans contact comprenant l'insert de la figure 1.

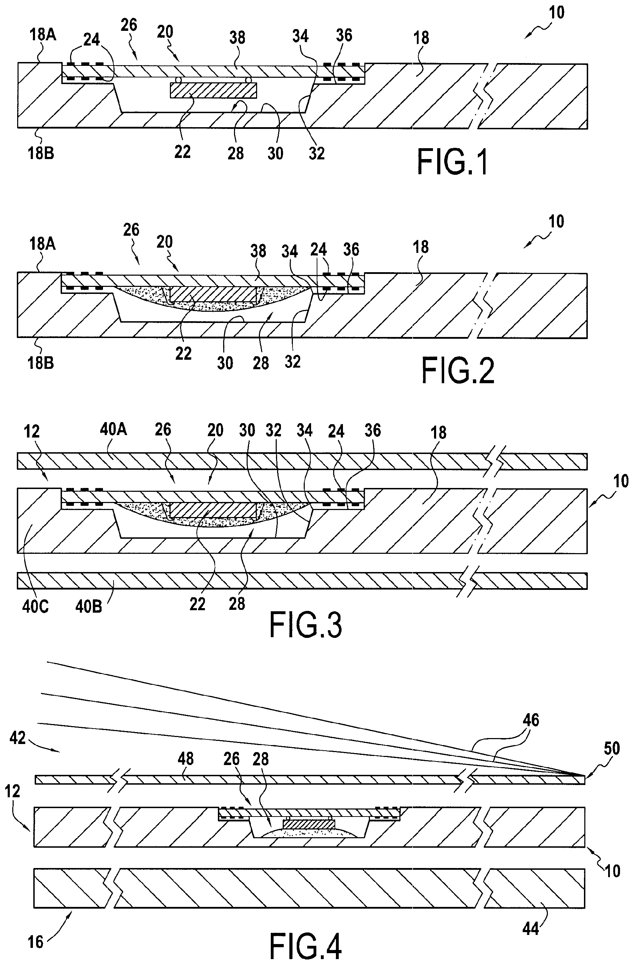

On a représenté sur **la** **figure 1** un insert selon un premier mode de réalisation de l'invention. Cet insert est désigné par la référence générale 10.

L'insert 10 est destiné à la fabrication d'un dispositif 12 comprenant un support formé par une structure multicouche à l'intérieur de laquelle l'insert 10 est destiné à être incorporé. Un tel dispositif 12 est par exemple une carte à microcircuit 14 (**figure 3**) ou encore un passeport 16 (**figure 4**).

L'insert 10 comprend, comme cela est illustré sur **la** **figure 1**, un substrat 18 et un ensemble transpondeur 20 comprenant un microcircuit 22 et une antenne 24 raccordée au microcircuit 22.

L'ensemble transpondeur 20 est, conformément à l'invention, regroupé dans un module à microcircuit 26. Le substrat 18 est réalisé par exemple dans une matière polymère, telle que du polychlorure de vinyle (PC), du polyester (PET, PETG), du polycarbonate (PC), de l'ABS, etc.

Par ailleurs, conformément à l'invention, le substrat 18 comprend une cavité 28 de réception du module 26 qui est dimensionnée pour recevoir entièrement le module 26, par exemple dans son épaisseur. Par exemple, l'épaisseur du substrat 18 est inférieure à 600 micromètres, et comprise de préférence entre 300 et 600 micromètres.

De préférence, le substrat 18 délimite des première 18A et deuxième 18B faces opposées, et la cavité 28 débouche sur l'une de ces faces, par exemple la face 18A.

La cavité 28 est délimitée dans cet exemple par un fond 30 et une paroi périphérique 32 entourant le fond. Cette paroi périphérique 32 comprend, dans l'exemple décrit, un gradin 34 formant un rebord interne 36 périphérique surélevé par rapport au fond 30.

Ainsi, la cavité 28 comprend une zone profonde délimitée par le fond 34 et la partie de la paroi périphérique inférieure au gradin 34 et une zone surélevée par rapport à la zone profonde délimitée par le rebord interne périphérique 36 et la partie supérieure de la paroi périphérique par rapport au gradin 34.

De préférence, le module 26 comprend un support 38. Ce support 38 est par exemple réalisé dans un matériau comprenant essentiellement de l'époxy et a par exemple une épaisseur inférieure à 200 micromètres et de préférence comprise entre 70 et 100 micromètres. Le support 38 repose par exemple sur le rebord interne 36.

De préférence, comme cela est illustré sur le premier mode de réalisation, le microcircuit 22 est assemblé par report de puce et est dit « monté-retourné » dans le module 26. Ce procédé d'assemblage est désigné couramment dans la terminologie anglo-saxonne par montage "flip-chip". Ce procédé d'assemblage se caractérise par une connexion électrique directe de la face active du microcircuit 22 sur le support pour le raccordement électrique avec des conducteurs appropriés sur le support.

Dans une variante illustrée sur **la** **figure 2**, le microcircuit peut être monté sur le support par un procédé de câblage appelé "Wire Bonding" qui consiste à coller le microcircuit sur le support par sa face passive et à câbler le microcircuit à partir de sa face active pour son raccordement électrique. Dans ce cas, le microcircuit et les câbles sont par exemple encapsulés dans une calotte de résine polymère.

Par ailleurs, l'antenne 24 s'étend autour du microcircuit 22 en périphérie du support 38.

De préférence, comme cela est illustré sur **la** **figure 1**, l'antenne 24 s'étend en deux parties sur chacune des faces du support 38 du module 26.

Le dispositif 12 de **la** **figure 3** est une carte à microcircuit 14. Par exemple, la carte à microcircuit 14 est conforme à la norme ISO 7816 et son format est le format ID-1 défini par cette même norme.

La carte 14 comprend un corps 40 formé par une structure multicouche comprenant au moins trois couches, une couche intermédiaire 40C intercalée entre deux couches externes 40A, 40B.

La couche intermédiaire 40C est formée par l'insert 10 de **la** **figure 2** et est intercalée entre les deux couches externes 40A, 40B qui forment des couches de compensation de l'épaisseur permettant de compenser les irrégularités de surface de l'insert 10.

De préférence, les couches 40A, 40B, 40C sont liées entre elles par lamination.

Le dispositif 12 représenté sur **la** **figure 4** est un passeport 16 comprenant un livret 42 muni d'une couverture 44 et d'un ensemble de feuillets 46 comportant entre autres une page de garde 48. Les feuillets 46 et la couverture 44 sont reliés entre eux par une ligne de reliure 50.

Sur **la** **figure 4**, on voit que l'insert 10 est intercalé entre la couverture 44 et la page de garde 48 pour former une structure multicouche. On voit sur cette figure que le microcircuit est monté selon le procédé d'assemblage « flip-chip ». En outre, dans cet exemple, le microcircuit est collé au fond de la cavité. Bien entendu, en variante, le microcircuit peut être également monté en « wire-bonding ».

De préférence, l'épaisseur de l'insert 10 est limitée par la hauteur du module 26 ainsi que l'épaisseur de la partie amincie formant le fond de la cavité 28.

Il est bien entendu que les modes de réalisation qui viennent d'être décrits ne présentent aucun caractère limitatif et qu'ils pourront recevoir toute modification désirable sans sortir pour cela du cadre de l'invention comme revendiquée. En particulier, il serait conforme à l'invention d'incorporer un insert dans tout dispositif de type à transpondeur.

## Revendications

1. Insert à transpondeur (10) pour la fabrication d'un dispositif (12) comprenant un support formé par une structure multicouche à l'intérieur de laquelle l'insert (10) est destiné à être incorporé, l'insert (10) comprenant un substrat (18) et un ensemble transpondeur (20) comprenant un microcircuit (22) et une antenne (24) raccordée au microcircuit (22), **caractérisé en ce que** l'ensemble transpondeur (20) est regroupé dans un module à microcircuit (26) **et en ce que** le substrat (18) comprend une cavité (28) dimensionnée pour recevoir entièrement le module (26),
dans lequel le module (26) comprend un support (38) portant le microcircuit (22) et l'antenne (24),
dans lequel, la cavité (28) étant délimitée par un fond (30) et une paroi périphérique (32), le microcircuit (22) est porté par le support (38) en regard du fond (30) de la cavité (28),
dans lequel la paroi périphérique (32) entoure le fond (30) et comprend un gradin (34) formant un rebord interne (36) périphérique surélevé par rapport au fond (30), le support (38) reposant sur le rebord interne (36).

2. Insert (10) selon la revendication précédente, dans lequel le substrat (18) délimite des première (18A) et deuxième (18B), faces opposées, la cavité (28) débouchant sur l'une des faces (18A).

3. Insert (10) selon l'une quelconque des revendications précédentes, dans lequel l'antenne (24) est formée par un enroulement de spires électriques conductrices.

4. Insert (10) selon la revendication 1, dans lequel l'antenne (24) s'étend en périphérie du support (38) de module (26).

5. Insert (10) selon l'une quelconque des revendications précédentes, dans lequel le microcircuit (22) est monté-retourné dans le module (26).

6. Dispositif (12) comprenant un support (38) formé par une structure en couche comprenant au moins trois couches (40A à 40C), une couche intermédiaire (40C) intercalée entre deux couches externes (40A, 40B), **caractérisé en ce que** la couche intermédiaire (40C) est un insert (10) selon l'une quelconque des revendications précédentes.

7. Dispositif (12) selon la revendication précédente, dans lequel les couches (40A à 40C) sont liées entre elles par lamination pour former un support laminé.

8. Dispositif (12) selon la revendication 6 ou 7, étant un passeport (16) ou une carte à microcircuit (14).

## Patentansprüche

1. Transpondereinsatz (10) zur Herstellung einer Vorrichtung (12) mit einem Träger, der durch eine Mehrschichtstruktur gebildet ist, in die der Einsatz (10) eingebaut werden soll,
wobei der Einsatz (10) ein Substrat (18) und eine Transponderanordnung (20) mit einer Mikroschaltung (22) und einer mit der Mikroschaltung (22) verbundenen Antenne (24) umfasst,
**dadurch gekennzeichnet, dass** die Transponderanordnung (20) in einem Mikroschaltungsmodul (26) zusammengefasst ist und dass das Substrat (18) einen Hohlraum (28) umfasst, der so bemessen ist, dass er das Modul (26) vollständig aufnehmen kann,
wobei das Modul (26) einen Träger (38) umfasst, der die Mikroschaltung (22) und die Antenne (24) trägt,
wobei der Hohlraum (28) durch einen Boden (30) und eine Umfangswand (32) begrenzt ist und die Mikroschaltung (22) von dem Träger (38) gegenüber dem Boden (30) des Hohlraums (28) getragen wird, und
wobei die Umfangswand (32) den Boden (30) umgibt und eine Stufe (34) umfasst, die einen inneren Umfangsrand (36) bildet, der in Bezug auf den Boden (30) erhöht ist, wobei der Träger (38) auf dem inneren Rand (36) aufliegt.

2. Einsatz (10) nach dem vorangehenden Anspruch, wobei das Substrat (18) erste (18A) und zweite (18B) gegenüberliegende Seiten begrenzt, wobei der Hohlraum (28) sich zu einer der Seiten (18A) öffnet.

3. Einsatz (10) nach einem der vorangehenden Ansprüche, wobei die Antenne (24) durch eine Wicklung aus elektrisch leitenden Spulen gebildet ist.

4. Einsatz (10) nach Anspruch 1, wobei sich die Antenne (24) um den Umfang des Trägers (38) des Moduls (26) erstreckt.

5. Einsatz (10) nach einem der vorangehenden Ansprüche, wobei die Mikroschaltung (22) in dem Modul (26) montiert und zurückgedreht ist.

6. Vorrichtung (12) mit einem Träger (38), der durch eine Schichtstruktur gebildet ist, die mindestens drei Schichten (40A bis 40C) umfasst, wobei eine Zwischenschicht (40C) zwischen zwei äußeren Schichten (40A, 40B) angeordnet ist, **dadurch gekennzeichnet, dass** die Zwischenschicht (40C) ein Einsatz (10) nach einem der vorangehenden Ansprüche ist.

7. Vorrichtung (12) nach dem vorangehenden Anspruch, wobei die Schichten (40A bis 40C) durch Laminieren miteinander verbunden sind, um einen laminierten Träger zu bilden.

8. Vorrichtung (12) nach Anspruch 6 oder 7, die ein Reisepass (16) oder eine Mikroschaltungskarte (14) ist.

## Claims

1. A transponder inlay (10) for manufacturing a device (12) comprising a carrier formed by a multilayer structure within which the inlay (10) is intended to be incorporated, the inlay (10) comprising a substrate (18) and a transponder assembly (20) comprising a microcircuit (22) and an antenna (24) connected to the microcircuit (22), **characterized in that** the transponder assembly (20) is grouped in a microcircuit module (26) **and in that** the substrate (18) comprises a cavity (28) sized to fully receive the module (26),
wherein the module (26) comprises a carrier (38) carrying the microcircuit (22) and the antenna (24),
wherein, the cavity (28) being delimited by a bottom (30) and a peripheral wall (32), the microcircuit (22) is carried by the carrier (38) facing the bottom (30) of the cavity (28),
wherein the peripheral wall (32) surrounds the bottom (30) and comprises a step (34) forming a peripheral inner rim (36) elevated relative to the bottom (30), the carrier (38) resting on the inner rim (36).

2. The inlay (10) according to the preceding claim, wherein the substrate (18) delimits first (18A) and second (18B) opposite faces, the cavity (28) opening onto one of the faces (18A).

3. The inlay (10) according to any one of the preceding claims, wherein the antenna (24) is formed by a winding of conductive electric turns.

4. The inlay (10) according to claim 1, wherein the antenna (24) extends at the periphery of the module (26) carrier (38).

5. The inlay (10) according to any one of the preceding claims, wherein the microcircuit (22) is flip-chip mounted in the module (26).

6. The device (12) comprising a carrier (38) formed by a layered structure comprising at least three layers (40A to 40C), an intermediate layer (40C) interposed between two outer layers (40A, 40B),
**characterized in that** the intermediate layer (40C) is an inlay (10) according to any one of the preceding claims.

7. A device (12) according to the preceding claim, wherein the layers (40A to 40C) are bonded together by lamination to form a laminated carrier.

8. The device (12) according to claim 6 or 7, being a passport (16) or a microcircuit card (14).
